# EUROPEAN PATENT APPLICATION

(11) **EP 0 953 966 A2**
(43) Date of publication of application: **03.11.1999**
(21) Application number: 99108715.6
(22) Date of filing: 30.04.1999
(51) Int. Cl.: G10L 3/00, H04M 11/06

(54) **Modem voice/data mode switching arrangement.**

(30) Priority: 01.05.1998 JP 12203098
(71) Applicant: NEC CORPORATION, Tokyo (JP)
(72) Inventor: Shinta, Minoru, c/o NEC Miyagi, Ltd., Kurokawa-gun, Miyagi (JP)
(74) Representative: Betten & Resch

(57) **Abstract**

A voice signal or a modem signal input into a transmitter is coded, and the coded signal is transmitted from the transmitter to a receiver through a digital transmission line. In this voice coding apparatus, when the input modem signal is a modem signal output from a high-speed modem, it is transmitted without low bit rate compression. By virtue of this constitution, the voice coding apparatus can realize high-speed modem transmission not involving a lowering in transmission speed.

## Description

### FIELD OF THE INVENTION

The invention relates to a voice coding apparatus, and more particularly to a voice coding apparatus that can cope with a high-speed modem signal output from a modem (modulator-demodulator) which can transmit information at a high speed.

### BACKGROUND OF THE INVENTION

Regarding communication systems utilizing digital transit trunks which are currently in widespread use, a large number of proposals have been made on compression of voice signals or modem signals, such as fax (facsimile) signals, before transit transmission, from the viewpoint of effectively utilizing the transit trunks. Examples of techniques associated with transit transmission utilizing the code compression include a code decoder disclosed in Japanese Patent Laid-Open No. 111633/1992 and a method for recovering faults in a voice compression device disclosed in Japanese Patent Laid-Open No. 189017/1994.

The coder / decoder comprises at least coding / decoding means for a voice signal, coding / decoding means for a modem signal, and means that can detect and judge a high-speed modem signal and, based on the results of input signal level monitoring and the results of detection and judgement of a low-speed modem signal which appears in the signal, can switch and control at least the coding / decoding means for a voice signal and the coding / decoding means for a modem signal. The clamed advantage of the codeer / decoder is that a plurality of algorithmo for code decoding are applicable to modem signals.

The method for recovering faults in a voice compression device comprises: a voice data compression section; an alarm transmitter which reads an alarm of a fax transit processor, a selection signal from a fax signal detector, and the status of use of a circuit from a controller, and determines alarm processing upon occurrence of a fault in the circuit based on the read information, wherein, during either voice communication or fax Communication, when a fault has occurred in the other, the call during communication is disconnected and blocked upon the termination of the communication. This permits the call during communication to be disconnected and blocked upon the termination of the communication and consequently contributes to improved communication reliability.

Further, a high efficiency terminal repeater equipment, for example, DCME (digital circuit multiplication equipment) recommended in ITU-T Rec. G. 763 is known as equipment that can efficiently perform transit transmission utilizing code compression of the type described above.

In this DCME, whether the input signal is a voice signal or a modem signal in a voice band is identified, and, based on the results of identification, low bit rate code compression suitable for signal characteristics of the voice signal or low bit rate code compression suitable for signal characteristics of the modem signal is performed, thereby realizing further efficient transmission.

DCME of ITU-T Rec. G. 763, however, cannot cope with modems which can perform high-speed transmission of 56 kbit/sec, such as X2 system, K56flex system, or ITU-T Rec. V. 90 system. Therefore, code compression by DCME creates distortion in a waveform that has passed through a coder and a decoder, resulting in occurrence of data error. This hinders high-speed modem transmission, and the fall back function of the modem lowers the transmission speed for the communication.

### SUMMARY OF THE INVENTION

Accordingly, it is an object of the invention to provide a voice coding apparatus that, in the case of a signal from a high-speed modem, low bit rate code compression is not performed, thereby realizing high-speed modem transmission not involving a lowering in transmission speed.

According to the first feature of the invention, a voice coding apparatus codes a voice signal or a modem signal input into a transmitter and transmits the coded signal from the transmitter to a receiver through a digital transmission line,
wherein when the input modem signal is a modem signal output from a high-speed modem, the signal is transmitted without low bit rate code compression.

According to the second feature of the invention, a voice coding apparatus codes a voice signal or a modem signal input into a transmitter and transmits the coded signal from the transmitter to a receiver through a digital transmission line,
the transmitter comprising
a voice/modem signal identifier which identifies whether the input signal is a voice signal or a modem signal and, if the input signal is a modem signal, identifies whether the modem signal is a modem signal not output from a high-speed modem or a high-speed modem signal output from a high-speed modem,
a low bit rate coder for a voice signal which performs low bit rate code compression of the input voice signal,
a low bit rate coder for a modem signal which performs low bit rate code compression of the input modem signal,
a first switch for the transmitter which, based on identification data output from the voice/modem signal identifier, switches the destination of output of the signal received from the voice/modem signal identifier and outputs the signal to the low bit rate coder for a voice signal if the identification data indicates that the signal is a voice signal, to the low bit rate coder for a modem signal if the identification data indicates that the signal is a modem signal not output from a high-speed modem, or directly without through the low bit rate coder for a modem signal if the identification data indicates that the signal is a high-speed modem signal,
a second switch for the transmitter which, based on identification data output from the voice/modem signal identifier, performs selection, switching, and output with respect to any or low bit rate coded data received from the low bit rate coder for a voice signal if the identification data indicates that the signal is a voice signal, low bit rate coded data received from the low bit rate coder for a modem signal if the identification data indicates that the signal is a modem signal not output from a high-speed modem, and coded data received from the first switch for the transmitter if the identification data indicates that the signal is a high-speed modem signal, and
a multiplexer for multiplexing the identification data output from the voice/modem signal identifier and the coded data output from the second switch for the transmitter,
   the receiver comprising
a separator which separates multiplexed identification data for a voice signal, a modem signal not output from a high-speed modem, or a high-speed modem signal and coded data in the input signal received from the digital transmission line,
a low bit rate decoder for a voice signal which decodes the input low bit rate coded data on a voice signal into the original voice signal,
a low bit rate decoder for a modem signal which decodes the input low bit rate coded data on a modem signal into the original modem signal,
a first switch for the receiver which, based on the identification data output from the separator, switches the destination of output of the coded data received from the separator and outputs the signal to the low bit rate decoder for a voice signal if the identification data indicates that the signal is a voice signal, to the low bit rate decoder for a modem signal if the identification data indicates that the signal is a modem signal not output from a high-speed modem, or directly without through the low bit rate decoder if the identification data indicates that the signal is a high-speed modem signal, and
a second switch for the transmitter which, based on the identification data output from the separator, performs selection, switching, and output with respect to any of a voice signal received from the low bit rate decoder for a voice signal if the identification data indicates that the signal is a voice signal, a modem signal received from the low bit rate decoder for a modem signal if the identification data indicates that the signal is a modem signal not output from a high-speed modem, and a high-speed modem signal received from the first switch for the receiver if the identification data indicates that the signal is a high-speed modem signal.

In the voice coding apparatuses according to the first and second features of the invention, voice signals or modem signals input into the transmitter except for modem signals output from a high-speed modem are coded by low bit rate code compression, and the data are transmitted from the transmitter to the receiver through the digital transmission line. According to this construction, signals output from a high-speed transmission modem do not undergo low bit rate code compression, realizing high-speed modem transmission not involving a lowering in transmission speed.

### BRIEF DESCRIPTION OF THE DRAWING

The invention will be explained in more detail in conjunction with the appended drawing, wherein:

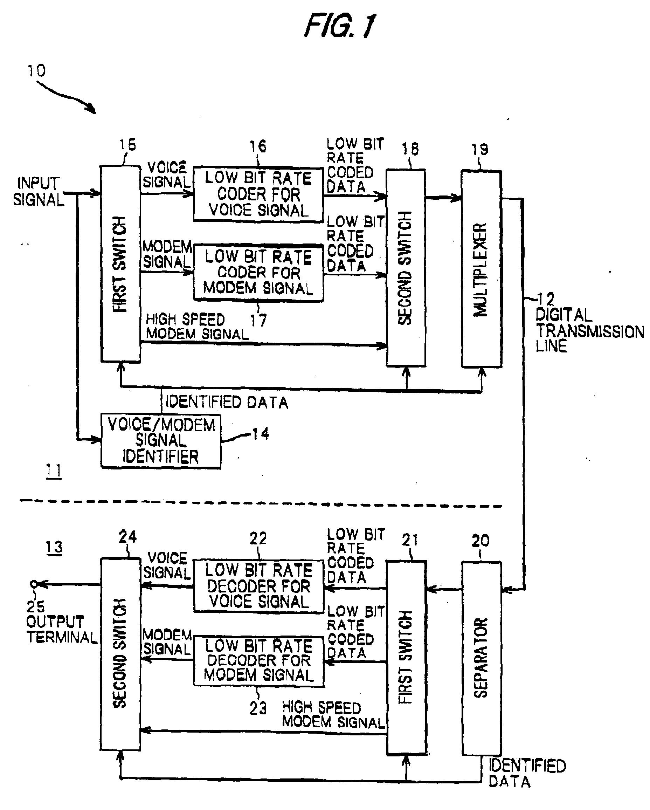

Fig. 1 is a functional block diagram of the voice coding apparatus according to a preferred embodiment of the invention.

### DESCRIPTION OF THE PREFERRED EMBODIMENTS

The voice coding apparatus in preferred embodiments of the invention will be explained in conjunction with Fig. 1.

Fig. 1 is a functional block diagram of the voice coding apparatus according to a preferred embodiment of the invention. As shown in Fig. 1, in a voice coding apparatus 10, a voice signal or a modem signal input into a transmitter 11 is compressed and coded, and the coded data is transmitted from the transmitter 11 to a receiver 13 through a digital transmission line 12. The voice signal or the modem signal input into the transmitter 11 is a PCM (pulse code modulation) coded signal.

The transmitter 11 comprises a voice/modem signal identifier 14, a first switch 15, a low bit rate coder 16 for a voice signal, a low bit rate coder 17 for a modem signal, a second switch 18, and a multiplexer 19.

The voice/modem signal identifier 14 identifies whether a signal a input into the transmitter 11 is a voice signal or a modem signal and, if the signal a is a modem signal, further identifies whether or not the modem signal is a signal output from a previously specified modem, that is, a high-speed modem. The results of the identification are output as identification data b from the voice/modem signal identifier 14 to the first switch 15, the second switch 18, and the multiplexer 19.

The first switch 15 switches the destination of output of the input signal a based on the identification data b, and outputs the input signal to the low bit rate coder 16 for a voice signal if the identification data b indicates that the signal is a voice signal a1, to the low bit rate coder 17 for a modem signal if the identification data b indicates that the signal is a modem signal a2 not output form a high-speed modem, and directly to the second switch 18 without through the low bit rate coder 17 for a modem signal if the identification data b indicates that the signal is a high-speed modem signal a3 output from a high-speed modem.

The low bit rate coder 16 for a voice signal functions to compress and code the input voice signal, and performs low bit rate code compression of the input voice signal a1 according to a coding algorithm (for example, ITU-T Rec. G. 726 32 kbit/s, 24 kbit/s, and 16 kbit/s ADPCM and ITU-T Rec. G. 728 LD-CELP). The low bit rate coder 16 outputs the results as low bit rate coded data c1 on the voice signal to the second switch 18.

The low bit rate coder 17 for a modem signal functions to compress and code the input modem signal, and performs low bit rate code compression of the input modem signal a2 according to a coding algorithm (for example, ITU-T Rec. G. 726 40 kbit/s ADPCM and 40 kbit/s LD-CELP). The low bit rate coder 17 outputs the results as low bit rate coded data c2 on the modem signal to the second switch 18.

The second switch 18 switches the destination of output of the input signal based on the identification data b, and outputs, to the multiplexer 19, low bit rate coded data c1 on the voice signal if the identification data b indicates that the signal is a voice signal; low bit rate coded data c2 on the modem signal if the identification data b indicates that the signal is a modem signal not output from a high-speed modem; and PCM coded data a3 on the modem signal if the identification data b indicates that the signal is a high-speed modem signal output from a high-speed modem.

The multiplexer 19 multiplexes any one of three coded data, c1, c2, and a3, output from the second switch 18 and the identification data b output from the voice/modem signal identifier 14 and outputs the multiplexed data. Specifically, the coded data is multiplexed with any one of an identification data indicating the application of low bit rate coding for a voice signal, corresponding to a voice coded data, an identification data indicating the application of low bit rate coding for a modem signal, corresponding to a modem signal coded data, or an identification data, corresponding to a high-speed modem signal coded data, indicating that the signal should be transmitted in the form of PCM without performing low bit rate coding.

The receiver 13 comprises a separator 20, a first switch 21, a low bit rate decoder 22 for a voice signal, a low bit rate decoder 23 for a modem signal, a second switch 24, and an output terminal 25 connected to the second switch 24.

The separator 20 separates the data input through the digital transmission line 12 into any one of the low bit rate coded data c1 on the voice signal, the low bit rate coded data c2 on the modem signal, or the PCM coded data a3 on the high-speed modem signal and the identification data b. After the separation, the coded data is output to the first switch 21, and the identification data b is output to the first switch 21 and the second switch 24.

The first switch 21 switches the destination of output of the input signal based on the identification data b, and outputs the input signal to the low bit rate decoder 22 for a voice signal if the identification data b indicates that the signal is a voice signal, to the low bit rate decoder 23 for a modem signal if the identification data b indicates that the signal is a modem signal not output from a high-speed modem, and directly to the second switch 24 if the identification data b indicates that the signal is a high-speed modem signal.

The low bit rate decoder 22 for a voice signal decodes the low bit rate coded data c1 on the voice signal into the voice signal a1 as the original PCM signal, while the low bit rate decoder 23 for a modem signal decodes the low bit rate coded data c2 on the modem signal into the voice signal a2 as the original PCM signal.

The second switch 24 switches the destination of output of the input signal based on the identification data b, and outputs, to the output terminal 25, the voice signal a1 decoded into the PCM signal if the identification data b indicates that the signal is a voice signal; the modem signal a2 decoded into the PCM signal if the identification data b indicates that the signal is a modem signal not output from a high-speed modem; and the high-speed modem signal a3 which is still in the form of the PCM signal, if the identification data b indicates that the signal is a high-speed modem signal.

According to the voice coding apparatus having the above construction, upon input of the voice signal or the modem signal into the transmitter 11, the voice/modem signal identifier 14 identities the input signal, and outputs the results to the first switch 15, the second switch 18, and the multiplexer 19.

When the input signal has been identified to be a voice signal a1, the signal is passed through the first switch 15, the low bit rate coder 16 for a voice signal, and the second switch 18. The low bit rate coded voice signal c1 is input into the multiplexer 19. On the other hand, when the input signal has been identified to be a modem signal a2 not output from a high-speed mode, the signal is passed through the first switch 15, the low bit rate coder 17 for a modem signal, and the second switch 18. The low bit rate coded modem signal c2 is input into the multiplexer 19. When the input signal has been identified to be a high-speed modem signal a3, the signal is output from the first switch 15 and directly passed through the second switch 18, and the PCM coded, high-speed modem signal a3 as such is input into the multiplexer 19.

Any one of the signals output from the transmitter 11, that is, the low bit rate coded voice signal c1, the low bit rate coded modem signal c2, and the high-speed modem signal a3 which has not been subjected to low bit rate coding and is in the form of PCM code, is input into the receiver 13 through the digital transmission line 12.

Upon input of any one of the signals c1, c2, and a3 into the receiver 13, the separator 20 separates the coded data based on the identification data b in the received digital data, and the separated data is then output to the first switch 21. The first switch 21 switches the destination of output or the signal based on the input identification data b, and outputs the coded data c1 to the low bit rate decoder 22 for a voice signal if the identification data b indicates that the signal is a voice signal; outputs the coded data c2 to the low bit rate decoder 23 for a modem signal if the identification data b indicates that the signal is a modem signal not output from a high-speed modem; and outputs the coded data a3 to the second switch 24 if the identification data b indicates that the signal is a high-speed modem signal.

The second switch 24 switches the destination of output of the signal based on the input identification data b, and outputs, to the output terminal 25, the voice signal a1 decoded by the low bit rate decoder 22 for a voice signal if the identification data b indicates that the signal is a voice signal, the modem signal a2 decoded by the low bit rate decoder 23 for a modem signal if the identification data b indicates that the signal is a modem signal not output from a high-speed modem, and directly the high-speed modem signal a3 output from the first switch 21 if the identification data b indicates that the signal is a high-speed modem signal.

Thus, according to the invention, the voice/modem signal identifier identifies whether the signal input into the transmitter 11 is a voice signal or a modem signal, and, when the signal has been identified to be a modem signal, further identifies whether the modem signal is a modem signal not output from a high-speed modem or a high-speed modem signal output form a high-speed modem. Based on the results of the identification, if the signal is a voice signal or a modem signal not output from a high-speed modem, the signal is subjected to low bit rate code compression and then transmitted, while if the signal is a high-speed modem signal, the signal is transmitted in the form of PCM coded data without low bit rate code compression.

Therefore, for example, unlike DCME of ITU-T Rec. G. 763 that does not cope with modems capable of performing high-speed transmission of 56 kbit/sec, such as X2 system, K56flex system, or ITU-T Rec. V. 90 system, according to the invention, there is no possibility that the modem signal output from a high-speed modem is unfavorably subjected to code compression by DCME, making it impossible to perform high-speed modem transmission and resulting in communication at lowered transmission speed. That is, according to the invention, since the signal from a high-speed modem is not subjected to low bit rate code compression, high-speed modem transmission not involving a lowering in transmission speed can be realized.

As described above, according to the invention, voice signals or modem signals input into the transmitter except for modem signals output from a high-speed modem are coded by low bit rate code compression, and the data are transmitted from the transmitter to the receiver through the digital transmission line. By virtue of this construction, for example, unlike DCME of ITU-T Rec. G. 763 that does not cope with modems capable of performing high-speed transmission of 56 kbit/sec, such as X2 system, K56flex system, or ITU-T Rec. V. 90 system, modem signals output from a high-speed modem are not subjected to low bit rate code compression by DCME, thereby realizing high-speed modem transmission not involving a lowering in transmission speed.

The invention has been described in detail with particular reference to preferred embodiments, but it will be understood that variations and modifications can be effected within the scope of the invention as set forth in the appended claims.

## Claims

1. A voice coding apparatus which codes a voice signal or a modem signal input into a transmitter and transmits the coded signal from the transmitter to a receiver through a digital transmission line,
wherein when the input modem signal is a modem signal output from a high-speed modem, the signal is transmitted without low bit rate code compression.

2. The voice coding apparatus according to claim 1, wherein the transmitter has identifying means for identifying whether or not the input modem signal is a modem signal output from a high-speed modem.

3. The voice coding apparatus according to claim 2, wherein the identifying means identifies whether the input signal is a voice signal or a modem signal, and, when the signal has been identified to be a modem signal, further identifies whether the modem signal is a modem signal not output from a high-speed modem or a high-speed modem signal output from a high-speed modem.

4. The voice coding apparatus according to claim 3, which comprises switching means for the transmitter which, based on the identification data output form the identifying means, outputs the voice signal to low bit rate coding means for a voice signal which performs low bit rate code compression, outputs the modem signal to low bit rate coding means for a modem signal which performs low bit rate code compression, and outputs the high-speed modem signal without low bit rate code compression.

5. The voice coding apparatus according to claim 4, which comprises switching means for the receiver which, based on the identification data output from the identifying means, outputs the voice signal subjected to low bit rate code compression to low bit rate decoding means for a voice signal which performs decoding, outputs the modem signal subjected to low bit rate code compression to low bit rate decoding means for a modem signal which performs decoding, and outputs, without decoding, the high-speed modem signal not subjected to low bit rate code compression.

6. A voice coding apparatus which codes a voice signal or a modem signal input into a transmitter and transmits the coded signal from the transmitter to a receiver through a digital transmission line,
said transmitter comprising
a voice/modem signal identifier which identifies whether the input signal is a voice signal or a modem signal and, if the input signal is a modem signal, identifies whether the modem signal is a modem signal not output from a high-speed modem or a high-speed modem signal output from a high-speed modem,
a low bit rate coder for a voice signal which performs low bit rate code compression of the input voice signal,
a low bit rate coder for a modem signal which performs low bit rate code compression of the input modem signal,
a first switch for the transmitter which, based on identification data output from the voice/modem signal identifier, switches the destination of output of the signal received from the voice/modem signal identifier and outputs the signal to the low bit rate coder for a voice signal if the identification data indicates that the signal is a voice signal; to the low bit rate coder for a modem signal if the identification data indicates that the signal is a modem signal not output from a high-speed modem; or directly without through the low bit rate coder for a modem signal if the identification data indicates that the signal is a high-speed modem signal,
a second switch for the transmitter which, based on identification data output from the voice/modem signal identifier, performs selection, switching, and output with respect to any of low bit rate coded data received from the low bit rate coder for a voice signal if the identification data indicates that the signal is a voice signal, low bit rate coded data received from the low bit rate coder for a modem signal if the identification data indicates that the signal is a modem signal not output from a high-speed modem, and coded data received from the first switch for the transmitter if the identification data indicates that the signal is a high-speed modem signal, and
a multiplexer for multiplexing the identification data output from the voice/modem signal identifier and the coded data output from the second switch for the transmitter,
said receiver comprising
a separator which separates multiplexed identification data for a voice signal, a modem signal not output from a high-speed modem, or a high-speed modem signal and coded data in the input signal received from the digital transmission line,
a low bit rate decoder for a voice signal which decodes the input coded data for a low bit rate voice signal into the original voice signal,
a low bit rate decoder for a modem signal which decodes the input coded data for a low bit rate modem signal into the original modem signal,
a first switch for the receiver which, based on the identification data output from the separator, switches the destination of output of the coded data received from the separator and outputs the signal to the low bit rate decoder for a voice signal if the identification data indicates that the signal is a voice signal, to the low bit rate decoder for a modem signal if the identification data indicates that the signal is a modem signal not output from a high-speed modem, or directly without through the low bit rate decoder if the identification data indicates that the signal is a high-speed modem signal, and
a second switch for the receiver which, based on the identification data output from the separator, performs selection, switching, and output with respect to any of a voice signal received from the low bit rate decoder for a voice signal if the identification data indicates that the signal is a voice signal, a modem signal received from the low bit rate decoder for a modem signal if the identification data indicates that the signal is a modem signal not output from a high-speed modem, and a high-speed modem signal received from the first switch for the receiver if the identification data indicates that the signal is a high-speed modem signal.
